Europäisches Patentamt

European Patent Office

Office européen des brevets

(19)

(11) Publication number: **0 138 346**
A2

(12)

# EUROPEAN PATENT APPLICATION

(21) Application number: **84305889.2**

(22) Date of filing: **29.08.84**

(51) Int. Cl.⁴: **H 03 B 5/36,** H 03 L 7/06, H 04 L 25/48

(30) Priority: **21.09.83 CA 437211**

(43) Date of publication of application: **24.04.85**
**Bulletin 85/17**

(84) Designated Contracting States: **AT DE FR GB NL SE**

(71) Applicant: **NORTHERN TELECOM LIMITED,**
**1600 Dorchester Boulevard West, Montreal Quebec**
**H3H 1R1 (CA)**

(72) Inventor: **Thomas, Terence Nell, 6 Kelowna Street,**
**Nepean Ontarlo, K2C 3H2 (CA)**
Inventor: **Hogeboom, John Gordon, 20 Dolan Drive,**
**Nepean Ontarlo, K2J 1V4 (CA)**

(74) Representative: **Crawford, Andrew Birkby et al, A.A.**
**THORNTON & CO. Northumberland House 303-306 High**
**Holborn, London WC1V 7LE (GB)**

(54) **Variable oscillator.**

(57) A variable oscillator, suitable for integration as part of a phase lock loop (PLL) clock source in a complementary metal oxide semiconductor (CMOS) integrated circuit, includes an amplifier and terminals for connection to a a tank circuit, for example a crystal resonator. A passive reactance is alternately coupled and decoupled in relation to the amplifier to cause oscillatory operation at lower and higher frequencies. In the CMOS circuit the reactance is conveniently provided by conductive layers of predetermined dimensions being carried by an oxide layer. Each layer provides a capacitive reactance which is arranged in series with a field effect defice being controlled by associated PLL control circuitry.

VARIABLE OSCILLATOR          0138346

The invention relates to oscillators and more particularly to oscillators which are variable in response to control apparatus such that preferred frequencies of electrical signal oscillations are obtained.

The invention is particularly useful in digital signal receiver circuits wherein data bit states of an information bit stream are determined by periodic sampling of the bit stream. The rate at which the bit stream is sampled is usually determined by one of two basic types of clock sources. In a case where signal excursions in the bit stream normally occur with frequent degrees of regularity, a suitable clock source may consist of a high Q resonant circuit followed by a squaring amplifier. In a case where signal excursions are of a less regular nature, the high Q resonant circuit may not receive enough energy from the bit stream to maintain sufficient oscillatory signal amplitude to continuously operate the squaring amplifier. In this case, a more expensive phase lock loop (PLL) clock source is usually employed. An all digital circuitry PLL uses a frequency signal of very much higher frequency than that of a required clock signal to generate the clock signal. Variable divide ratio logic circuitry is adjusted in phase by increments as small as but no smaller than half the period of the higher frequency signal to provide the clock signal with controlled phase. Alternately a more analog phase lock loop circuit usually includes a phase comparator for generating an error signal representative of phase error between an output of the PLL clock source and signal excursions in the bit stream. An oscillator, usually an amplifier with a tank circuit connected across the amplifier, is used as a source of the required clock pulses. The frequency of oscillation is made to be variable by including a variable capacitance diode, usually referred to as a varactor diode, in the oscillator so that the frequency of oscillation is varied in response to the error signal.

One solution to reducing the cost of the PLL clock source has been to integrate it in silicon technology with other elements of a typical digital signal receiver. One of the most economical present day integrated circuit technologies for implementing an integrated digital signal receiver is known as complementary metal oxide silicon technology, or CMOS. Unfortunately the all digital circuitry PLL requires circuit functional speed which is not conveniently available in integrated CMOS technology. In the case of the more analog PLL the high frequency problem is avoided but it is difficult to a point of being cost prohibitive to include a variable capacitance diode in a typical CMOS integrated circuit structure.

The invention provides an oscillator circuit and method which is useful as a clock source. The oscillator circuit is particularly suited for inclusion in an integrated circuit structure. Controlled variability of frequency of oscillation is achieved by providing a capacitive reactance and a field effect transistor switch for connecting the capacitive reactance to the oscillator. The field effect transistor is controlled from time to time to connect the capacitive reactance to change the frequency of oscillation of the oscillator such that an average frequency of oscillation is that required for operating the digital receiver.

The invention also includes the oscillator circuit in phase lock loop configurations, and includes a phase lock loop circuit having long term stability and being operable to converge rapidly toward a desired operating frequency.

In accordance with the invention a variable oscillator includes an oscillator circuit having an amplifier with terminals for connection to a tank circuit. A switch is operable for connecting and for disconnecting a passive reactance element with the oscillator circuit so that the oscillator circuit is operable at either of first and second frequencies.

Also in accordance with the invention a method for providing clock signals for use in a receiver includes the steps of:

a) causing an oscillator to be operative at either of two frequencies which are respectively lower and higher than an integer multiple of a frequency of a received signal;

b) generating a phase error signal in response to a phase comparison between the received signal and the operating frequency of the oscillator; and

c) switching the oscillator back and forth between the two frequencies whereby an average value of the phase error signal corresponds to a preferred predetermined value of the phase error signal.

An example embodiment is discussed with reference to the accompanying drawings in which:

Figure 1 is a schematic diagram of a variable oscillator in accordance with the invention;

Figure 2 is a schematic diagram of a variable oscillator similar to figure 1 and particularly adapted to being convenient for fabrication in an integrated circuit form;

Figure 3 is a block schematic diagram of a phase lock loop circuit which uses the variable oscillator of figure 2 to provide clock signals for a diphase signal digital receiver; and

Figure 4 is a block schematic diagram of a phase lock loop circuit which uses the variable oscillator of figure 2 to provide clock signals for a bipolar digital signal receiver.

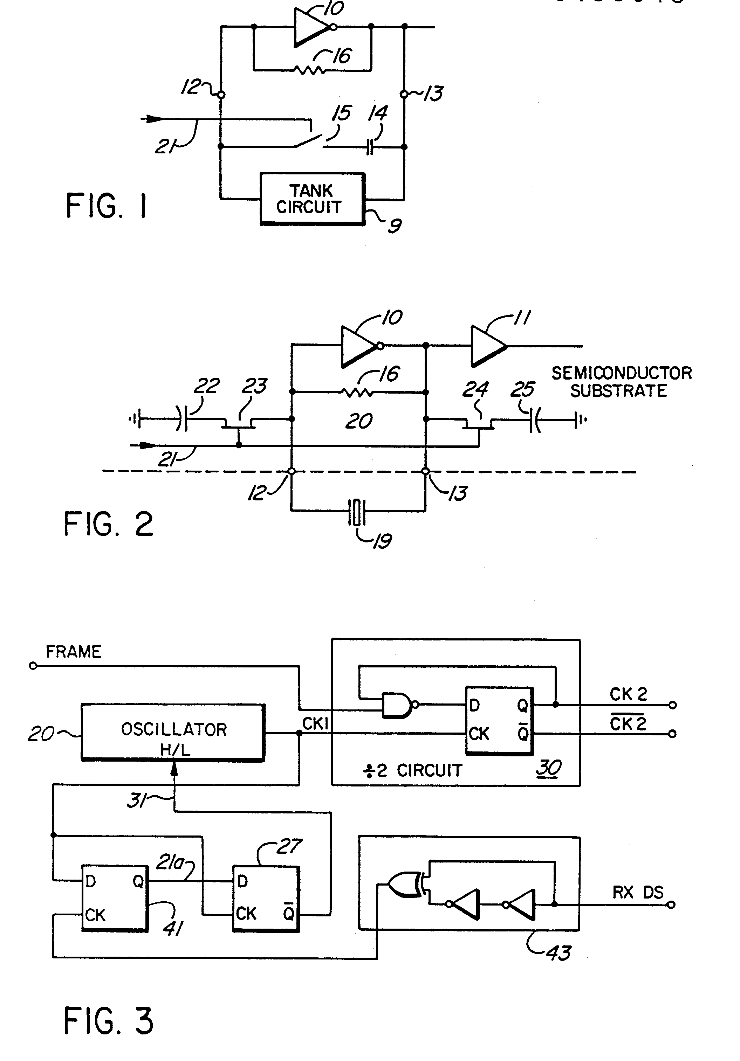

Referring to figure 1, an inverting amplifier 10 is connected across a tank circuit 9 via terminals 12 and 13 for oscillatory operation. A capacitor 14 is connected in series with a switch 15 which is controllable to be open or closed such that two frequencies of oscillation, higher and lower, are available.

Referring to figure 2, elements of the same function as those in figure 1 are labelled with a corresponding number. All of the elements, other than the tank circuit provided by a crystal 19, reside in a semiconductor material substrate. Terminals 12 and 13 provide for connection of a crystal 19 which provides the function of the tank circuit 9 in figure 1. The output of the amplifier 10 is shielded from possible loading effects of on-following circuitry, not shown, by a buffer amplifier 11. A capacitive reactance element 22 is coupled between ground and the input of the amplifier via a FET switch 23. Similarly a capacitive reactance element 25 is coupled between ground and the output of the amplifier 10 via a FET switch 24. The capacitive reactance elements 22 and 25 are each conveniently provided by respective areas of conductors carried on a dielectric layer having been formed over another conductive layer in the substrate.

In operation the FETs 23 and 24 are controlled to be conductive or non-conductive via a control path 21. When the FETs are conductive, the frequency of the oscillator is lower than when the FETs are non-conductive. Hence the average frequency of the oscillator is controllable to be between the lower and higher frequencies by switching between the two frequencies as required.

5

Referring to figure 3, elements of the same function as those in figure 2 are labelled with a corresponding number. The oscillator 20 is operated at the higher and lower frequencies in accordance with the binary signal state of its high low control input H/L. The output of the oscillator 20 is connected to a divide-by-two circuit as exemplified in circuit block 30. The output of the oscillator circuit 20 provides a first clock signal CK1 which is divided by two to generate clock signals in two phases CK2 and CK2 inverted for use in associated circuitry of a digital signal receiver, not shown. A frame lead provides for control of generation and half period phase of the clock signals CK2 and CK2 inverted. The circuitry in figure 3 is particularly suited for providing clock signals for a receiver of binary data as may be encoded for transmission in a diphase signal stream. The diphase signal stream is received from an output of an associated diphase signal receiver (not shown) on a receive diphase signal lead labelled RXDS. A strobe generator exemplified by circuitry in a circuit block 43 responds to each transition in the diphase signal stream by asserting a narrow positive going strobe at a clock input CK of a D type flip flop 41. This causes the instantaneous state of the first clock signal CK1 to be clocked into the flip flop 41. If the state of CK1 is high, its phase is early, and if its state is low, its phase is late. If the phase of CK1 is early, the Q output of the flip flop 41 is clocked high. If the phase of the clock signal CK1 is late, the Q output is clocked low. The state of the Q output of the flip flop 41 appears on a lead 21a and can be used directly to control the frequency of the oscillator 20 to be correspondingly of the lower or higher frequencies. However this can cause undesirable phase shifts or glitches in the output of the oscillator 20. When the FETs 23 and 24 are switched on at a time without reference to the clock signal CK1, it is very likely that the voltages stored in the capacitors 22 and 25 are different than the instant voltages at the terminals 12 and 13. Operation of the oscillator 20 is improved by phase synchronizing signal transitions at its H/L input. A D type flip flop 27, connected as shown, is used to retime changes in the control signal on the lead 21a so that transitions occur on the lead 21 at consistently similar moments of phase angle with respect to the oscillatory signal CK1.

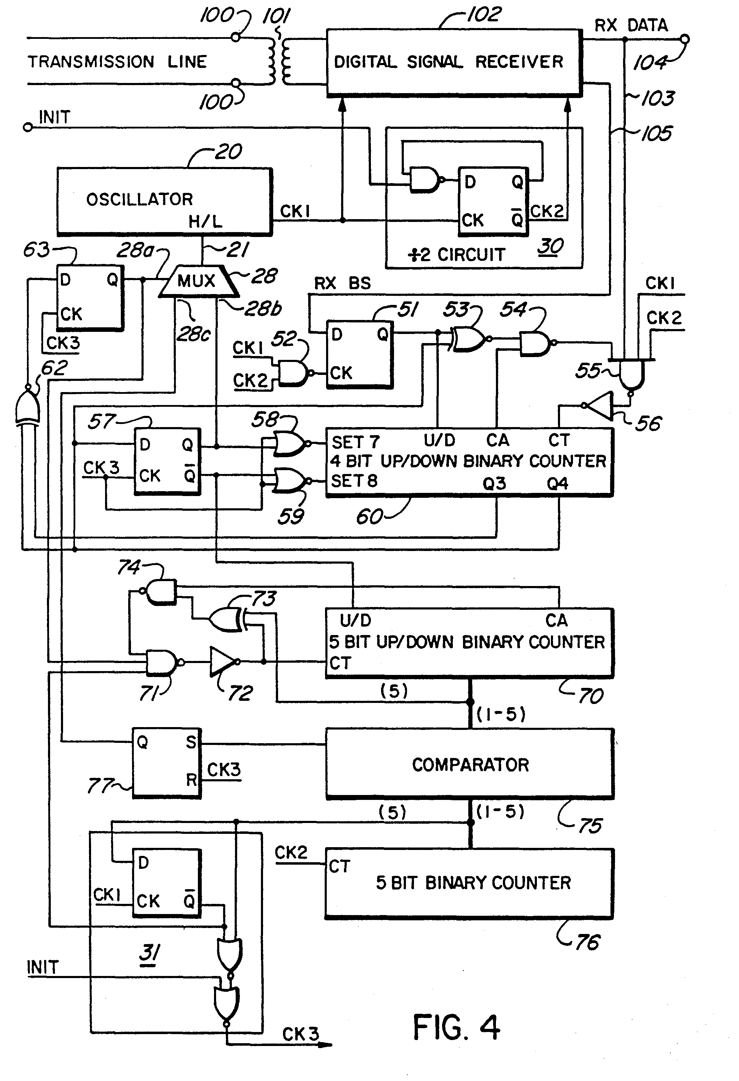

In figure 4 elements having similar functions as those in the preceding figures are labelled with corresponding numbers. Referring to figure 4, a digital signal receiver 102 is coupled to transmission line terminals 100 via a transformer 101, for receiving for example a bipolar return to zero (BPRZ) signal stream. A BPRZ signal stream is characterized in that binary information bits of one state are represented by signal excursions of alternate polarity while binary information bits of the other state are represented by an absence of signal excursion. Thus in comparison to the diphase signal previously discussed, there can be periods of time when the BPRZ signal stream has significantly less timing information as compared to a diphase signal stream of a similar information bit content. The digital signal receiver 102 operates in response to clock signals CK1 and CK2 from the oscillator circuit 20 and from the divide-by-two circuit 30 to generate a binary data bit stream on a receive data lead 103 labelled RX DATA, the binary data bit stream corresponding to an information content of the received BPRZ signal stream. The digital receiver 102 also operates to provide a raw bit stream on a lead 105 labelled RBS. The raw bit stream is an intermediate by-product of generating the binary data bit stream and is valuable for timing information as will be described.

The H/L control input of the oscillator 20 in figure 4 is connected via the lead 21 to an output of a multiplexer 28. The multiplexer 28 includes an address input 28a, the signal state of which determines which of signals at inputs 28b and 28c are used to select the instant frequency of the oscillator 20. A fast control signal at the input 28b is used to control the oscillator to rapidly attain a preferred phase, and originates with circuitry including a first group of circuit elements labelled 51 through 60. A slower control signal at control input 28c is used to cause the oscillator 20 to substantially maintain a preferred phase relationship once such phase relationship has been achieved. The slower control signal originates with a second group of circuit elements labelled 70 through 77.

In the first group of circuit elements, a 4-bit up/down binary counter 60 counts positive going portions of the received data bit stream in response to signals applied at its count input CT. A D type flip flop 51, NAND gates 52, 54 and 55, an EXCLUSIVE NOR gate 53 and an inverter 56 are connected as shown to control the direction and counting functions of the 4-bit up/down binary counter 60. Raw bit stream signal states on the lead 105 are clocked into the flip flop 51 in response to a logical NANDing of the clock signals CK1 and CK2. A Q output of the flip flop 51 is used to control count direction of the counter 60 via its up/down input U/D. The output of the flip flop 51 is EXCLUSIVE NORed with a most significant output Q4 of the counter 60 by the gate 53. In the event the counter 60 is at an extreme end of its count range, as would be indicated by an assertion of its carry output CA, and the most significant bit and the count directions are of the same state, a stop count is asserted by the NAND gate 54. This prevents any further assertions of the received data bit stream at the count input CT. Thus the counter 60 is prevented from counting past either end of a predetermined range and only begins to count again when the state of the Q output of the flip flop 51 changes, that is when it becomes opposite to the state of the counter 60 output Q4.

The state of the Q4 output of the counter 60 is periodically clocked into a D type flip flop 57 by an asymmetrical clock signal CK3 which occurs at 1/64 of the rate of the clock signal CK2. The clock signal CK3 is generated by circuitry as exemplified in circuit block 31. A Q output of the flip flop 57 is connected to the input 28b to supply the fast control signal. The Q output and a Q inverted output of the flip flop 57 are NORed with the clock signal CK3 at NOR gates 58 and 59 respectively. SET 7 and SET 8 inputs of the counter 60 are each responsive to a positive going edge from the output of the respective NOR gate to accordingly set the counter 60 at a count of seven or eight.

A multiplexer 28 is addressed via a D type flip flop 63 which is periodically updated in response to the clock CK3 with an EXCLUSIVE NORing of the states of the outputs Q3 and Q4 of the binary counter 60. Thus when the states of these outputs are the same, the multiplexer 28 causes the selection of the higher and lower oscillator frequencies to be determined by the state of the flip flop 57. Otherwise the selection is determined by the state of a set reset flip flop 77 in the second group of circuit elements 70 through 77.

The second group of circuit elements includes a 5-bit binary up/down counter 70. Logic circuitry 71 - 74, connected as shown, is responsive to the states of the most significant output (5) and the carry output CA of the counter 70, and the state of the flip flop 63 to gate clock pulses, of the CK3 clock rate, from the circuit block 31. The up/down counter 70 responds to the gated clock pulses as they are asserted at its count input CT to either count up or count down, depending upon the state of the flip flop 57. Thus at every 64th occurrence of a CK2 clock pulse the counter 70 is incremented either up or down in accordance with the instant state of the Q4 output of the counter 60. A 5-bit binary counter 76 is connected to count solely in response to the clock signal CK2 to provide a time reference. The outputs of the counters 76 and 70 are compared to each other in a comparator 75. The flip flop 77 is periodically reset by the clock signal CK3 and thereafter set in response to each match occurrence between the outputs of the counters 70 and 76. Thus when the oscillator 20 is being controlled by the slower control signal, in a series of 128 pulses of the clock signal CK1 some pulses are generated by the oscillator 20 at the high frequency and the remainder are generated at the lower frequency.

This is in contrast to the alternate case wherein the phase angle of the oscillator output is consistently advanced or retarded throughout each block of 128 pulses of CK1 when the oscillator 20 is under the direct control of the first group of circuit elements 51 through 60.

The result of operation of the circuit in figure 4 during more or less regular transitions in the BPRZ bit stream is to provide a very closely phase controlled clock signal being predominantly dictated by the slower control signal. During prolonged absence of transitions in the BPRZ bit stream, control continues to be dictated by the slow control signal. However the ratio of the higher and lower frequency control portion of the control signal are incremented either up or down in accordance with the state of the Q4 output of the counter 60. As the counter 60 remains static in the absence of transistion in the BPRZ

0138346

signal, this will eventually cause the slow control signal to be non-saturated. However when transition again begins to occur with some frequent regularity in the BPRZ signal, consistent phase error is detected by the flip flop 51 which in turn causes the fast control signal to dictate the operation of the oscillator 20 which causes a rapid correction of the phase of the clock signal toward the preferred phase.

CLAIMS:

1. A variable oscillator including an amplifier (10) being provided by an arrangement of metal oxide semiconductor devices being defined in a semiconductor substrate and terminal means (12, 13) for connecting a tank circuit (9) to the amplifier for causing oscillatory operation at a first frequency, the variable oscillator being characterized by:

a passive reactance element (14) and a metal oxide semiconductor switch device (15) also being defined in the semiconductor substrate, the switch device being operable to connect the passive reactance in combination with the amplifier for causing the oscillatory operation to occur at a second frequency.

2. A variable oscillator as defined in claim 1 wherein the capacitive reactance comprises an area of conductive material being carried by a layer of dielectric material which resides on another conductive layer in the substrate.

3. A variable oscillator as defined in claim 2 wherein the switch device includes a plurality of field effect transistor switches, each of the terminal means being connected in series with one of the field effect transistor switches, and wherein the variable oscillator includes capacitive reactances corresponding to each of the terminal means and being electrically connectable in series therewith via the respective field effect transistor switches.

4. A variable oscillator as defined in claim 3 wherein the capacitive reactances each comprise, an area of conductive material being carried by a layer of dielectric material, the layers of dielectric material residing on a common conductive layer in the substrate.

5. A method of providing clock signals for use in a receiver, comprising the steps of:

a) causing an oscillator to be operative at either of two frequencies which are respectively lower and higher than an integer multiple of a frequency of a signal being received;

b) generating a phase error signal in response to a phase comparison between the received signal and the operating frequency of the oscillator;

c) switching the oscillator back and forth between the two frequencies whereby an average value of the phase error signal corresponds to a preferred predetermined value of the phase error signal.

6. A method as defined in claim 5 wherein the switching of the oscillator is accomplished by coupling a capacitive reactance with the oscillator to obtain the lower frequency and by decoupling the capacitive reactance to obtain the higher frequency.

7. A method of controlling an oscillator being operable at predetermined lower and higher frequencies for generating a clock signal of a preferred average frequency for use in a receiver of a digital signal bit stream, the method comprising the steps of:

i) controlling up and down directions of counting of occurrences of a predetermined characteristic in the bit stream in response to the phase of the clock being late or early with respect to transitions in the bit stream and terminating said counting when a count value reaches a predetermined range limit;

ii) defining a periodic timing interval having a period being an integer multiple of the period of the clock signal;

iii) providing a fast control signal corresponding to a most significant bit of the count at moments being defined by the timing interval and thereafter setting the value of the count to a value intermediate of the limits of the range;

iv) gating the fast control signal to the oscillator in response to a count corresponding to one of the range limits at moments being defined by the timing interval;

v) controlling up and down directions of counting of timing interval occurrences in response to corresponding fast control signal states when the fast control signal is being gated to the oscillator;

vi) generating a slow control signal having first and second signal states during each time interval, with a moment of transition between the two states being defined by a count value at an end of each timing interval occurrence; and

vii) gating the slow control signal to the oscillator in response to a count of step i) being intermediate the range limit at moments defined by the timing interval.

FIG. 1

FIG. 2

SEMICONDUCTOR SUBSTRATE

FIG. 3

FIG. 4